(19) Europäisches Patentamt
European Patent Office
Office européen des brevets

(11) **EP 1 227 354 A2**

(12) **EUROPÄISCHE PATENTANMELDUNG**

(43) Veröffentlichungstag:
**31.07.2002 Patentblatt 2002/31**

(51) Int Cl.⁷: **G02B 17/08**, G03F 7/20

(21) Anmeldenummer: **02000562.5**

(22) Anmeldetag: **10.01.2002**

(84) Benannte Vertragsstaaten:
**AT BE CH CY DE DK ES FI FR GB GR IE IT LI LU MC NL PT SE TR**
Benannte Erstreckungsstaaten:
**AL LT LV MK RO SI**

(30) Priorität: **24.01.2001 DE 10104177**

(71) Anmelder: **CARL ZEISS SEMICONDUCTOR MANUFACTURING TECHNOLOGIES AG**
**73447 Oberkochen (DE)**

(72) Erfinder:
• **Perrin, Jean Claude, Dr.**
  **71640 Givry (FR)**
• **Epple, Alexander, Dr.**
  **73431 Aalen (DE)**
• **Ulrich, Wilhelm**
  **73434 Aalen (DE)**

(74) Vertreter: **Muschik, Thomas (DE)**
**Patentanwälte Ruff, Wilhelm,**
**Beier, Dauster & Partner,**
**Kronenstrasse 30**
**70174 Stuttgart (DE)**

(54) **Katadioptrisches Reduktionsobjektiv**

(57) Ein katadioptrisches Projektionsobjektiv zur zwischenbildfreien Abbildung eines in einer Objektebene (2) angeordneten Musters in eine Bildebene (3) hat zwischen der Objektebene und der Bildebene in dieser Reihenfolge einen ersten Objektivteil (4) zur Erzeugung eines auf einen physikalischen Strahlteiler (5) gerichteten, divergenten Strahls, einen physikalischen Strahlteiler (5) mit einer Strahlteilerfläche (6), eine Spiegelgruppe (7) mit einem Konkavspiegel (8) sowie einen zweiten Objektivteil (9) mit positiver Brechkraft zur Erzeugung eines Bildes des Musters in der Bildebene (3). Die Spiegelgruppe (7) hat vorzugsweise keine freistehende Linse und eine im wesentlichen durch den Abbildungsmaßstab des Konkavspiegels (8) bestimmte Spiegelgruppenbrechkraft, die so groß ist, daß die auftreffende divergente Strahlung in eine konvergente Strahlung umgewandelt wird. Die Systemblende liegt bildseitig hinter dem Konkavspiegel (8), bevorzugt am Ausgang des Strahlteilers.

Fig. 1

**Beschreibung**

Die Erfindung betrifft ein katadioptrisches Projektionsobjektiv zur Abbildung eines in einer Objektebene angeordneten Musters in eine Bildebene.

Derartige Projektionsobjektive werden in Projektionsbelichtungsanlagen zur Herstellung von Halbleiterbauelementen und anderen feinstrukturierten Bauteilen verwendet, insbesondere in Waferscannern und Wafersteppern. Sie dienen dazu, Muster von Photomasken oder Strichplatten, die nachfolgend allgemein als Masken oder Retikel bezeichnet werden, auf einen mit einer lichtempfindlichen Schicht beschichteten Gegenstand mit höchster Auflösung in verkleinerndem Maßstab zu projizieren.

Dabei ist es zur Erzeugung immer feinerer Strukturen notwendig, einerseits die bildseitige numerische Apertur (NA) des Projektionsobjektivs zu vergrößern und andererseits immer kürzere Wellenlängen zu verwenden, vorzugsweise Ultraviolettlicht mit Wellenlängen von weniger als ca. 260 nm.

In diesem Wellenlängenbereich stehen nur noch wenig ausreichend transparente Materialien zur Herstellung der optischen Komponenten zur Verfügung, insbesondere synthetisches Quarzglas und Fluoridkristalle, wie Calciumfluorid, Magnesiumfluorid, Lithium-Kalzium-Aluminium-Fluorid, Lithium-Strontium-Aluminium-Fluorid, Bariumfluorid, Lithiumfluorid oder dergleichen. Da die Abbékonstanten der verfügbaren Materialien relativ nahe beieinanderliegen, ist es schwierig, rein refraktive Systeme mit ausreichender Korrektur von Farbfehlern (chromatische Aberration) bereitzustellen. Dieses Problem wäre durch Nutzung rein reflektiver Systeme grundsätzlich lösbar. Jedoch ist die Herstellung derartiger Spiegelsysteme aufwendig.

In Anbetracht der obigen Probleme sind für höchstauflösende Projektionsobjektive der genannten Art vorzugsweise katadioptrische Systeme geeignet, bei denen brechende und reflektierende Komponenten, insbesondere also Linsen und Spiegel, kombiniert sind.

Bei der Nutzung von abbildenden Spiegelflächen ist es vorteilhaft, Strahlteiler einzusetzen, wenn eine obskurationsfreie und vignettierungsfreie Abbildung erreicht werden soll. Es sind sowohl Systeme mit geometrischen Strahlteilern, als auch solche mit physikalischen Strahlteilern bekannt. Ein System mit geometrischer Strahlteilung, die mit Hilfe von zwei Umlenkspiegeln erfolgt, ist in der EP 0 989 434 (entsprechend US Serial Nr. 09/364382) offenbart. Systeme mit geometrischer Strahlteilung haben den Nachteil, daß es sich aufgrund der geometrischen Strahlteilung zwingend um off-axis Systeme handelt. Mit Hilfe eines physikalischen Strahlteilers sind dagegen on-axis Systeme realisierbar.

Ein System mit physikalischem Strahlteiler und Zwischenbild ist aus der EP-A-0 475 020 (entsprechend US 5,052,763) bekannt. Dieses System hat wenigstens ein katadioptrisches Eingangssystem sowie ein dioptrisches Ausgangssystem. Die abzubildende Maske liegt direkt auf einem Strahlteiler auf, der als Strahlteilerwürfel (beam splitter cube, BSC) ausgeführt ist. Mit Hilfe des Strahlteilers wird ein Teil des vom katadioptrischen System reflektierten Lichtes zum dioptrischen System abgelenkt. Durch die Anordnung des abzubildenden Objektes direkt auf dem Strahlteiler sind die Korrekturmöglichkeiten für das Gesamtsystem eingeschränkt. Zudem führt dieses Kontaktverfahren zu extremen Anforderungen an Materialqualität sowie zu mechanischen Problemen wegen eines fehlenden Arbeitsabstandes.

Aus der EP-A-0 350 955 (entsprechend US-A-4,953,960) ist ein katadioptrisches Projektionsobjektiv ohne Zwischenbild bekannt, bei dem zwischen der Objektebene und einem physikalischen Strahlteiler eine erste Linsengruppe, zwischen dem physikalischen Strahlteiler und einem Hohlspiegel eine zweite Linsengruppe und zwischen dem physikalischen Strahlteiler und der Bildebene eine dritte Linsengruppe vorgesehen ist. Die zwischen Strahlteiler und Hohlspiegel angeordnete Linsengruppe soll Koma niedriger Ordnung und sphärische Aberration des Spiegels sowie den Gaußfehler korrigieren.

Aus der DE-A-42 03 464 (entsprechend US-A-5,402,267) ist ein katadioptrisches Projektionsobjektiv mit physikalischem Strahlteiler und ohne Zwischenbild bekannt, das bei günstiger Konstruktion und geringer Justierempfindlichkeit hohe bildseitige numerische Aperturen von mindestens 0,5 ermöglicht. Dieses System zeichnet sich im wesentlichen dadurch aus, daß zwischen dem Hohlspiegel und dem Strahlteiler keine Linsengruppe angeordnet ist und daß der Hohlspiegel eine erhebliche Reduktionswirkung, also einen stark verkleinernden Abbildungsmaßstab hat. Die Korrektur der chromatischen Längsaberration (CHL) wird im wesentlichen durch einen stark konvergenten Strahlengang in Strahlteilerwürfel erzielt und kann zu einer Vollachromatisierung der chromatischen Längsaberration führen. Typischerweise ist dabei der Strahlengang vor dem Spiegel, d.h. im ersten Durchgang durch den Strahlteiler, nahezu oder im wesentlichen kollimiert, während der Strahlengang nach dem Spiegel, d.h. im zweiten Durchgang durch den Strahlteiler, normalerweise stark konvergiert. Die Systemblende liegt bevorzugt am Ort des Hohlspiegels und wird durch dessen Rand definiert. Die Blende kann auch auf der spiegelseitigen Grenzfläche des Strahlteilers oder zwischen Spiegel und Strahlteiler definiert sein. Der stark konvergente Strahlengang nach dem Hohlspiegel bietet als weiteren Vorteil, daß nach dem Strahlteiler nur wenig positive Brechkraft vorgesehen sein muß und daß in diesem Bereich relativ kleine Strahlhöhen vorliegen, so daß negative Einflüsse auf die chromatische Aberration aufgrund hoher Strahlhöhen in diesem Bereich vermieden werden. Projektionsobjektive mit diesen oder vergleichbaren konstruktiven und funktionalen Merkmalen werden für die Zwecke dieser Anmeldung als Typ I bezeichnet.

Den Vorteilen von Typ I-Objektiven steht als ein Nachteil gegenüber, daß die Strahlung besonders beim zweiten Durchgang nach Reflexion an Konkavspiegel konvergent auf die Strahlteilerfläche trifft, so daß an dieser ein sehr großer Inzidenzwinkelbereich auftritt. Dies stellt erhöhte Anforderungen an die Qualität der Strahlteilerschicht. Außerdem führt die starke Konvergenz des Strahlenganges nach dem Hohlspiegel dazu, daß hinter dem Strahlteiler nur wenig Bauraum für Linsen und damit wenige Korrekturmittel zur Verfügung stehen. Eine weitere Erhöhung der bildseitigen numerischen Apertur würde eine Vergrößerung des Strahlteilerwürfels erfordern und weiterhin bedingen, daß die Bildebene noch näher an den Strahlteiler heranrückt. Daher gelten Projektionsobjektive vom Typ I auch als aperturbegrenzt.

Grundsätzlich ähnliche Probleme treten auch bei anderen Projektionsobjektiven auf, die hinsichtlich Aufbau und Strahlengang gemäß Typ I ausgebildet sind. Hierzu zählen beispielsweise die in den US-Patenten US-A-6,118,596, US-A-6,108,140, US-A-6,101,047 gezeigten Projektionsobjektive. Hohe Inzidenzwinkel an der Strahlteilerfläche können auch bei Systemen auftreten, bei denen ein Zwischenbild erzeugt wird, wie es z.B. in der US 5,808,805 oder der US 5,999,333 gezeigt ist.

Aus der US-A-5,771,125 ist ein zwischenbildfreies, katadioptrisches Projektionssystem mit physikalischem Strahlteiler bekannt, bei dem die Strahlung im ersten Durchgang durch die Strahlteilerschicht schwach divergiert, während sie im zweiten Durchgang nach Reflexion am Hohlspiegel kollimiert ist. Dadurch sollen Verschlechterungen der Bildqualität aufgrund der Abhängigkeit des Reflexionsgrades der Strahlteilerschicht vom Inzidenzwinkel vermieden werden. Die Kollimation des reflektierten Lichts wird dadurch erreicht, daß die Brechkraft der den Hohlspiegel umfassenden Spiegelgruppe relativ gering gehalten wird. Bei dem System der EP-A-0 602 923 (entsprechend US-A-5,715,084) ist dagegen vor dem physikalischen Strahlteiler eine Positivlinse vorgesehen, um die im ersten Durchgang auf die Strahlteilerschicht fallende Strahlung zu kollimieren. Nach Reflexion am Hohlspiegel verläuft sie konvergent.

Um die Inzidenzwinkel auf der Strahlteilerschicht zu minimieren, schlägt die DE-A-44 17 489 (entsprechend US-A-5,742,436) vor, bei einem zwischenbildfreien katadioptrischen Projektionssystem mit physikalischem Strahlteiler objektseitig vor dem physikalischen Strahlteiler wenigstens eine Sammellinse zur Parallelisierung des auf die Strahlteilerschicht auftreffenden Lichtstrahls anzuordnen und nach dem physikalischen Strahlteiler im katadioptrischen Objektivteil, d.h. zwischen dem Strahlteiler und dem Hohlspiegel, eine zerstreuende Linsengruppe mit einer Negativlinse vorzusehen, um die Wirkung der dem Strahlteiler vorgeschalteten Sammellinse zu kompensieren und eine Korrektur der chromatischen Längsaberration herbeizuführen. Bei diesem Design, das für die Zwecke dieser Anmeldung als Typ II bezeichnet wird, liegt die Systemblende hinter dem Strahlteilerwürfel und der Strahlengang im Strahlteilerwürfel ist in beiden Durchgangsrichtungen im wesentlichen kollimiert.

Da der Strahlengang im Strahlteilerwürfel in beiden Durchgangsrichtungen im wesentlichen kollimiert ist, werden die bei großen Inzidenzwinkelbereichen auftretenden Probleme vermieden. Ein weiterer Vorteil des kollimierten Strahlenganges im zweiten Durchgang nach Reflexion am Hohlspiegel liegt darin, daß bildseitig des Strahlteilers im Blendenraum genügend Platz zum Einbau von Korrekturmitteln zur Verfügung steht. Nachteilig an der Anordnung gemäß der DE-A-44 17 489 ist es, daß die Korrektur des Farblängsfehlers (CHL) nur unvollständig ist.

Es ist eine Aufgabe der Erfindung, ein katadioptrisches Projektionsobjektiv mit physikalischer Strahlteilung anzugeben, das Nachteile des Standes der Technik vermeidet. Insbesondere soll bei sehr großer bildseitiger numerischer Apertur und günstiger Konstruktion eine nahezu vollständige chromatische Korrektur ermöglicht werden. Dies soll bei geringem Materialeinsatz hinsichtlich Masse und/oder Anzahl der optischen Komponenten erreicht werden.

Zur Lösung dieser Aufgabe schlägt die Erfindung ein katadioptrisches Projektionsobjektiv mit den Merkmalen von Anspruch 1 vor. Vorteilhafte Weiterbildungen sind in den abhängigen Ansprüchen angegeben. Der Wortlaut sämtlicher Ansprüche wird durch Bezugnahme zum Inhalt der Beschreibung gemacht.

Ein erfindungsgemäßes katadioptrisches Projektionsobjektiv, das ein in der Objektebene angeordnetes Muster in eine Bildebene abbildet, hat zwischen Objektebene und Bildebene in dieser Reihenfolge einen ersten Objektivteil zur Erzeugung eines auf einen physikalischen Strahlteiler gerichteten Strahls, einen physikalischen Strahlteiler mit einer Strahlteilerfläche, eine Spiegelgruppe mit einem Konkavspiegel bzw. Hohlspiegel und einer Spiegelgruppenbrechkraft und einen zweiten Objektivteil mit positiver Brechkraft zur Erzeugung eines Bildes des Musters in der Bildebene, wobei die Spiegelgruppenbrechkraft groß ist und die Systemblende bildseitig hinter dem Konkavspiegel liegt.

Die große Brechkraft der Spiegelgruppe ermöglicht eine Strahlführung, bei der das Licht divergent auf die Spiegelgruppe trifft und konvergent Richtung Strahlteilerfläche austritt. Dadurch ist es möglich, daß der Strahlteiler sowohl im ersten Durchgang, als auch im zweiten Durchgang mit nichtkollimiertem Licht durchstrahlt wird und aufgrund des schrägen Lichtdurchtrittes zur chromatischen Korrektur beitragen kann. Vorteilhaft hierfür ist, wenn die Summe der Beträge der paraxialen Randstrahlwinkel beim ersten Durchgang und beim zweiten Durchgang groß gegen Null ist. Die Betragssumme der paraxialen Randstrahlwinkel liegt vorzugsweise bei mehr als 30% oder 40% der numerischen Apertur, insbesondere kann sie im Bereich um 60% der numerischen Apertur liegen. Gleichzeitig sorgt die Anordnung der Systemblende bildseitig hinter dem Konkavspiegel dafür, daß auch bei hohen bildseitigen numerischen Aperturen im Bereich bildseitig hinter dem Strahlteiler die maximalen Strahlhöhen auf vertretbare Werte begrenzt bleiben, so daß sich bei der Konstruktion des zweiten Objektivteils keine Schwierigkeiten aufgrund großer Linsendurchmesser ergeben. Als Systemblende wird hier der axiale Ort bezeichnet, bei dem der Hauptstrahl die optische Achse schneidet. Bevorzugt ist eine Position der Systemblende zwischen Strahlteilerfläche und Bildebene, insbesondere nahe oder an der bildseitigen Austrittsfläche des Strahlteilers. Die Abbildung erfolgt vorzugsweise ohne Erzeugung eines Zwischenbildes.

Vorzugsweise ist der erste Objektivteil so ausgelegt, daß ein auf den Strahlteil gerichteter divergenter Strahl erzeugt wird. Bevorzugt sind stark divergierende Strahlen, bei denen Randstrahlwinkel auftreten, die größer als ca. 20% der bildseitigen numerischen Apertur und beispielsweise im Bereich zwischen 30% und 40% der bildseitigen numerischen Apertur liegen können. Als Randstrahlwinkel u wird hier das Produkt aus Brechungsindex n des durchlaufenden Mediums und dem Sinus des Winkels zwischen Randstrahl und optischer Achse bezeichnet.

Eine starke Strahldivergenz bei günstigen Objektivteildurchmesser wird bei bevorzugten Ausführungsformen dadurch erzielt, daß der erste Objektivteil vor dem Strahlteiler negative Brechkraft, vorzugsweise mindestens zwei Negativlinsen, zur Erzeugung einer Taille im Strahlengang aufweist.

Weiterhin ist es vorteilhaft, wenn die Spiegelgruppenbrechkraft so groß ist, daß der Strahl bildseitig hinter der Spiegelgruppe konvergent ist. Zur Erzielung eines wesentlichen Beitrages zur chromatischen Korrektur hat es sich als zweckmäßig erwiesen, wenn der austretende konvergente Strahl einen Randstrahlwinkel hat, der größer als ca. 10% der bildseitigen numerischen Apertur des Projektionsobjektivs ist. Andererseits sollte stark konvergente Strahlung vermieden werden, um hinter dem Strahlteiler ausreichend Bauraum für Linsen und andere der Strahlbeeinflussung dienende optische Komponenten zu ermöglichen. Daher sollten die Randstrahlwinkel ca. 30% der bildseitigen numerischen Apertur nicht oder nicht wesentlich überschreiten.

Zweckmäßig ist der Betrag des Randstrahlwinkels im ersten Durchgang vor der Spiegelgruppe größer als nach Reflexion am Spiegel. Vorzugsweise wird eine starke Divergenz vor dem Spiegel in eine betragsmäßig schwächere Konvergenz nach dem Spiegel umgewandelt, so daß der wesentliche Beitrag zur chromatischen Korrektur schon im ersten Durchtritt durch den Strahlteiler erfolgt.

Besonders bevorzugt sind Ausführungsformen, bei denen zwischen der Strahlteilerfläche und dem Konkavspiegel keine freistehende Linse angeordnet ist. Der Konkavspiegel hat bevorzugt einen vergrößernden Abbildungsmaßstab. Er trägt mit großer Brechkraft und ohne chromatische Aberrationen einzuführen zur Gesamtbrechkraft bei. Ferner korrigiert er die Petzvalsumme des Projektionsobjektivs.

Durch die Erfindung ist es möglich, die chromatische Korrektur zu einem überwiegenden Teil vor Eintritt in den zweiten Objektivteil, also vor allem im Bereich von Strahlteiler und Spiegelgruppe durchzuführen. Daher kann der zweite Objektivteil im Hinblick auf Dimensionierung und Materialbedarf besonders günstig aufgebaut sein. Insbesondere ist es nicht notwendig, stark wirksame chromatische Korrekturmittel vorzusehen, so daß der zweite Objektivteil, zumindest im Bereich großer Strahlhöhen, d.h. mit gewissem Abstand von der Bildebene, Linsen aus nur einem einzigen Material aufweisen kann. Ausführungsformen der Erfindung zeichnen sich dadurch aus, daß im wesentlichen alle transparenten optischen Bauelemente aus einem einzigen Material bestehen, beispielsweise aus Calciumfluorid bzw. Flußspat ($CaF_2$) oder synthetischem Quarzglas ($SiO_2$). Bei Verwendung von $SiO_2$ kann im Bereich nahe der Bildebene, wo hohe Leistungsdichten der Strahlung auftreten, z.B. zur Vermeidung von "Compaction"-Problemen, ein zweites strahlungsunempfindliches Material, wie $CaF_2$ vorgesehen sein. Bei dem überwiegend oder ausschließlich verwendeten Linsenmaterial kann es sich somit um Calciumfluorid oder ein anderes fluoridisches Kristallmaterial handeln, insbesondere wenn das System für Wellenlängen von weniger als ca. 160 nm ausgelegt ist. Für größere Wellenlängen, beispielsweise um 193 nm, ist auch eine überwiegende oder ausschließliche Verwendung von synthetischem Quarzglas möglich.

Um bei geringem Materialeinsatz eine gute monochromatische Korrektur bzw. hohe Abbildungsleistung und niedrige Aberrationen bei sehr großer numerischer Apertur zu erreichen, können in einer Ausführungsform eine oder mehrere asphärische Flächen vorgesehen sein, wobei i.d.R. eine größere Anzahl von Asphären vorgesehen ist, jedoch vorzugsweise nicht mehr als acht. Dabei ist es besonders im Hinblick auf die Korrektur der sphärischen Aberration und von Koma zweckmäßig, wenn mindestens eine asphärische Fläche im Bereich der Systemblende angeordnet ist. Hier ist eine besonders wirksame Korrektur dann gegeben, wenn für diese Fläche das Verhältnis h/φ zwischen der Randstrahlhöhe h an der Fläche und dem Radius φ der Öffung der Systemblende zwischen ca. 0,8 und ca. 1,2 liegt. Die Randstrahlhöhe sollte also bei der asphärischen Fläche nahe der maximalen Randstrahlhöhe liegen.

Um eine wirksame Korrektur der Verzeichnung und sonstiger Feldaberrationen zu ermöglichen, ist zweckmäßig auch in Feldnähe, also nahe am Retikel, bzw. an der Objektebene und/oder nahe am Wafer bzw. der Bildebene, mindestens eine asphärische Fläche vorgesehen. Diese feldnahen Flächen zeichnen sich dadurch aus, daß bei Ihnen das Verhältnis h/φ kleiner als ca. 0,8 ist. Günstig ist es, wenn mindestens eine Asphäre in Feldnähe und mindestens eine Asphäre in Nähe der Systemblende angeordnet ist. Dadurch ist es möglich, für alle angesprochenen Abbildungsfehler eine ausreichende Korrektur bereitzustellen.

Die vorstehenden und weitere Merkmale gehen außer aus den Ansprüchen auch aus der Beschreibung und den Zeichnungen hervor, wobei die einzelnen Merkmale jeweils für sich allein oder zu mehreren in Form von Unterkombinationen bei einer Ausführungsform der Erfindung und auf anderen Gebieten verwirklicht sein und vorteilhafte sowie für sich schutzfähige Ausführungen darstellen können. Es zeigen

Fig. 1 eine Linsenschnittdarstellung einer ersten Ausführungsform der Erfindung,

Fig. 2 eine Linsenschnittdarstellung einer dritten Ausführungsform der Erfindung,

Fig. 3 eine Linsenschnittdarstellunng einer fünften Ausführungsform der Erfindung und

Fig. 4 eine Linsenschnittdarstellung einer sechsten Ausführungsform der Erfindung.

Bei der folgenden Beschreibung bevorzugter Ausführungsformen bezeichnet der Begriff "optische Achse" eine gerade Linie oder eine Folge von geraden Linienabschnitten durch die Krümmungsmittelpunkte der optischen Komponenten. Die optische Achse wird an Umlenkspiegeln oder reflektierenden Flächen gefaltet. Richtungen und Abstände werden als bildseitig beschrieben, wenn sie in Richtung der Bildebene bzw. des dort befindlichen, zu belichtenden Substrates gerichtet sind und als "objektseitig", wenn sie in Bezug auf die optische Achse zum Objekt gerichtet sind. Das Objekt ist in den Beispielen eine Maske (Retikel) mit dem Muster einer integrierten Schaltung, es kann sich aber auch um ein anderes Muster, beispielsweise eines Gitters, handeln. Das Bild wird in den Beispielen auf einem als Substrat dienenden mit einer Photoresistschicht versehenen Wafer gebildet, jedoch sind auch andere Substrate, beispielsweise Elemente für Flüssigkristallanzeigen oder Substrate für optische Gitter möglich. Im folgenden werden identische oder einander entsprechende Merkmale der verschiedenen Ausführungsformen aus Gründen der Übersichtlichkeit mit den gleichen Bezugszeichen bezeichnet.

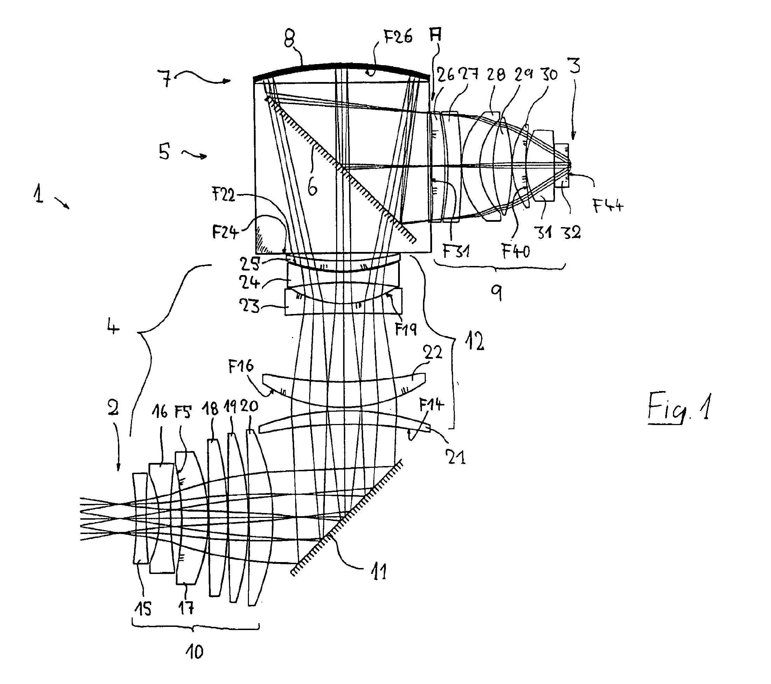

Ein typischer Aufbau eines erfindungsgemäßen katadioptrischen Reduktionsobjektives 1 ist anhand eines ersten Ausführungsbeispiels in Fig. 1 gezeigt. Es dient dazu, ein in einer Objektebene 2 angeordnetes Muster eines Retikels oder dergleichen in eine Bildebene 3 in reduziertem Maßstab abzubilden, beispielsweise im Verhältnis 4:1. Das Objektiv 1 hat zwischen der Objektebene 2 und der Bildebene 3 in der angegebenen Reihenfolge einen ersten Objektivteil 4, einen physikalischen Strahlteiler 5 mit einer Strahlteilerfläche 6, eine Spiegelgruppe 7 mit einem Konkavspiegel 8 und einen dem Strahlteiler nachgeschalteten zweiten Objektivteil 9 mit positiver Brechkraft zur Erzeugung eines Bildes des Musters in der Bildebene 3.

Der erste Objektivteil 4 hat im Anschluß an die Objektebene 2 eine erste Linsengruppe 10, einen um 45° zur optischen Achse geneigten, ebenen Umlenkspiegel 11 und zwischen diesem und dem Strahlteiler 5 eine zweite Linsengruppe 12. Der Umlenkspiegel 11 ermöglicht es in Verbindung mit dem Strahlteiler 5, die in der Objektebene 2 angeordnete Maske parallel zum in der Bildebene 3 angeordneten Wafer auszurichten, wodurch ein Scannerbetrieb von Maske und Wafer erleichtert wird. Statt der gewinkelten Form des ersten Objektteils ist auch eine gerade Form ohne Umlenkspiegel 11 möglich.

Wie in Fig. 1 erkennbar, tritt das Licht aus einem (nicht gezeigten) Beleuchtungssystem auf der bildabgewandten Seite der Objektebene 2 in das Projektionsobjektiv ein und durchtritt dabei die in der Bildebene angeordnete Maske. Das transmittierte Licht durchtritt die erste Linsengruppe 10, wird am Umlenkspiegel 11 in Richtung der zweiten Linsengruppe 12 reflektiert und durchtritt diese Richtung Strahlteiler 5. Im Strahlteiler durchtritt das Licht die im Winkel von ca. 45° zur optischen Achse angeschrägte, ebene Strahlteilerfläche 6 und fällt nach Durchtritt durch eine (nicht gezeigte) Viertelwellenplatte auf die konkave, reflektierende Fläche des Hohlspiegels 8. Von dieser reflektiert durchtritt das Licht erneut die Viertelwellenplatte, bevor es auf die Strahlteilerschicht 6 fällt, die das Licht nun Richtung Bildebene 3 reflektiert. Nach Austritt aus dem Strahlteiler durchtritt das Licht den zweiten Objektivteil 9, der ein Bild der Maske auf einer lichtempfindlichen Fläche des in der Bildebene angeordneten Wafers erzeugt.

Die erste Linsengruppe 10 umfasst, ausgehend von der Objektebene 2 eine bikonkave Negativlinse 15, eine weitere bikonkave Negativlinse 16, eine Meniskuslinse 17, deren konkave Fläche F5 zur Objektebene 2 weist, eine Bikonvexlinse 18 mit einer nur schwach gekrümmten objektseitigen Fläche, eine weitere Bikonvexlinse 19 mit einer schwach gekrümmten objektseitigen Fläche und eine Miniskuslinse 20 mit einer objektseitigen konkaven Fläche.

Die dem Umlenkspiegel 11 folgende zweite Linsengruppe 12 beginnt mit einer Meniskuslinse 21 mit objektseitiger Konkavfläche F13, auf die eine umgekehrt gekrümmte Miniskuslinse 22 folgt, deren objektseitige Fläche F15 konvex ist.

Mit axialem Abstand zur Meniskusgruppe 21, 22 folgt eine Negativlinse 23 mit stark konkav gekrümmter Austrittsfläche F18 auf die eine weitere bikonkave Negativlinse 24 folgt. Der Abschluß des ersten Objektivteils sowie der zweiten Linsengruppe 12 wird durch eine Meniskuslinse 25 mit bildseitiger Konkavfläche gebildet, aus der ein stark divergenter Strahl Richtung Strahlteiler 5 austritt.

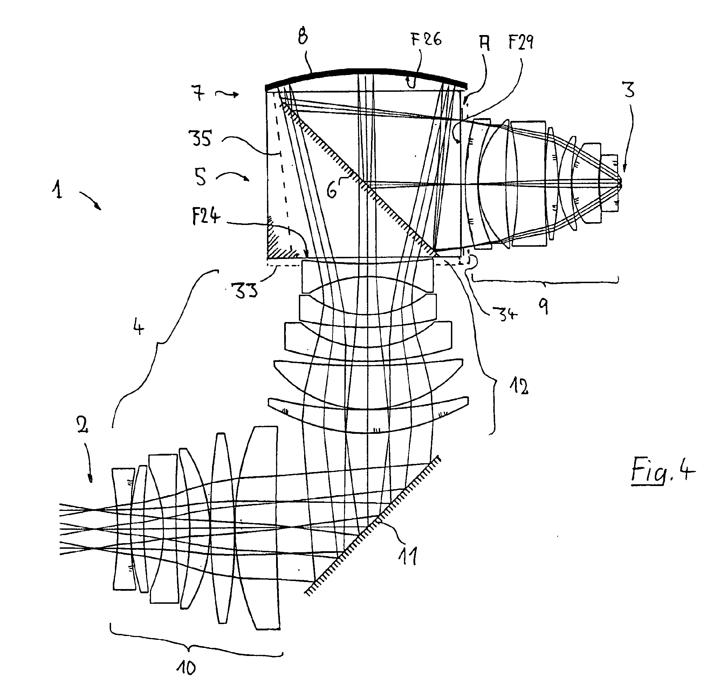

Der Strahlteiler 5 umfaßt bei der gezeigten Ausführungsform zwei im Bereich der Strahlteilerfläche 6 miteinander verbundene Rechteckprismen, die einen Strahlteilerwürfel (beam splitter cube, BSC) bilden. Bei anderen Ausführungsformen (vgl. Fig. 4) ist eine von der Würfelform abweichende Form vorgesehen, beispielsweise eine regelmäßige oder unregelmässige Minimalform bezüglich des Materialvolumens, die an den Strahlverlauf innerhalb des Strahlteilers so angepaßt ist, daß im wesentlichen keine nichtdurchstrahlten Bereiche vorhanden sind. Im Bereich der Strahlteilerfläche 6 ist eine dünne optisch wirksame Schicht vorgesehen, die bei der gezeigten Ausführungsform so konstruiert ist, daß das vom ersten Objektivteil 4 kommende polarisierte Licht transmittiert und das vom Spiegel 8 kommende Licht nach zweimaligem Durchtritt durch die Viertelwellenlängenschicht und eine damit verbundene Drehung der Polarisationsvorzugsrichtung um 90° Richtung Bildebene reflektiert wird. Es handelt sich also um einen Polarisationsstrahlteiler, bei dem Lichtverluste im Vergleich zu ebenfalls möglichen teildurchlässigen Spiegelschichten im Bereich der Strahlteilerfläche minimiert sind.

Bei einer nicht gezeigten Ausführungsform ist die im Bereich der Strahlteilerfläche 6 vorgesehene Strahlteilerschicht so ausgelegt, daß das vom ersten Objektivteil kommende Licht zunächst in Richtung eines Hohlspiegels reflektiert wird, der sich auf der dem zweiten Objektivteil 9 gegenüberliegenden Seite des Strahlteilers befindet. Das von diesem Hohlspiegel reflektierte Licht wird nach zweimaligem Durchtritt durch eine Viertelwellenlängenschicht von dieser Strahlteilerschicht 6 dann in Richtung Bildebene 3 transmittiert. Alternativ zu den beschriebenen Strahlteilern ist es auch möglich, einen physikalischen Strahlteiler durch eine schräg in den Strahlengang gestellte planparallele Platte zu realisieren.

Nach Austritt aus dem Strahlteiler 5 tritt das Licht in den zweiten Objektivteil 9 ein. Diese umfaßt in Lichtdurchtrittsrichtung eine Positivlinse 26, deren zum Strahlteiler gerichtete Fläche nur schwach gekrümmt ist, eine Negativ-Meniskuslinse 27 mit objektseitiger Konkavfläche, eine stark gekrümmte Meniskuslinse 28 mit bildseitiger Konkavfläche, eine bikonvexe Positivlinse 29, eine Meniskuslinse 30 mit bildseitiger Konkavfläche, eine dicke, bikonvexe Positivlinse 31 und eine abschließende Meniskuslinse 32, deren nahezu ebene und parallel zueinander verlaufende Flächen schwach in Richtung Objekt gekrümmt sind.

In Tabelle 1 ist die Spezifikation des Designs in bekannter Weise in tabellarischer Form zusammengefaßt. Dabei gibt Spalte 1 die Nummer der brechenden oder reflektierenden Fläche F, Spalte 2 den Radius r der Fläche (in mm), Spalte 3 den als Dicke bezeichnenden Abstand d der Fläche zur nachfolgenden Fläche (in mm) und Spalte 4 den als Index bezeichneten Brechungsindex des Materials des Bauelementes an, das der Eintrittsfläche folgt. In Spalte 5 sind die reflektierenden Flächen gekennzeichnet.

Bei der Ausführungsform sind acht der Flächen, nämlich die Flächen F5, F16, F19, F22, F26 (Spiegelfläche), F31, F40 und F44 asphärisch. Tabelle 2 gibt die entsprechenden Asphärendaten an, wobei sich die asphärischen Flächen nach folgender Vorschrift berechnen:

$$p(h)=[((1/r)h^2)/(1+SQRT(1-(1+K)(1/r)^2h^2)]+C1*h^4+C2*h^6+....$$

Dabei gibt der Kehrwert (1/r) des Radius die Flächenkrümmung und h den Abstand eines Flächenpunktes von der optischen Achse an. Somit gibt p(h) die sogenannten Pfeilhöhe, d.h. den Abstand des Flächenpunktes vom Flächenscheitel in z-Richtung, d.h. in Richtung der optischen Achse. Die Konstanten K, C1, C2, ... sind in Tabelle 2 wiedergegeben.

Das mit Hilfe dieser Angaben reproduzierbare optische System 1 ist für eine Arbeitswellenlänge von ca. 157 nm ausgelegt, bei der das für alle Linsen verwendete Linsenmaterial Calciumfluorid einen Brechungsindex n=1,55841 hat. Die bildseitige numerische Apertur NA beträgt 0,85.

Das zwischenbildfreie System zeichnet sich durch einige im Folgenden näher erläuterte Besonderheiten aus. Die dem Spiegel 11 vorgeschaltete erste Linsengruppe 10 hat positive Brechkraft, um das vom Objekt kommende Licht zu bündeln. Dieses tritt nach Reflexion am Umlenkspiegel 11 in die zweite Linsengruppe 12 ein. Die beiden gegenläufig gekrümmten Menisken 21, 22 am Eingang des zweiten Objektivteils haben insgesamt positive Brechkraft und verengen den Strahtdurchmesser weiter, so daß die mit großem Abstand folgende Dreiergruppe der Linsen 23, 24 und 25 aus Linsen mit geringem Durchmesser aufgebaut sein kann. Die konvergierende Strahlung wird durch die Dreiergruppe, im wesentlichen durch die beiden unmittelbar aufeinanderfolgenden Negativlinsen 23 und 24 unter Bildung einer Taille im Strahlengang in einer stark divergierende Strahlung umgewandelt, die auf die Eintrittsfläche F24 des Strahlteilers 5 trifft. Durch die Erzeugung einer Taille im Strahlengang ist es möglich, bei relativ geringen Linsendurchmessern in der Nähe des Strahlteilers eine starke Divergenz im Strahlengang zu realisieren, bei der der minimale Randstrahlwinkel typischerweise größer als ca. 20% oder 30% und kleiner als ca. 40% der bildseitigen numerischen Apertur des Projektionsobjektives 1 ist. Gleichzeitig kann der Strahlteilerwürfel klein gehalten werden.

Die divergente Strahlung durchtritt die Strahlteilerfläche 6 Richtung Hohlspiegel 8. Die Krümmung seiner reflektierenden Fläche F26 ist so bemessen, daß die vom Spiegel reflektierte Strahlung zwar konvergent ist, der Betrag des maximalen Randstrahlwinkels jedoch kleiner ist als derjenige der einfallenden divergenten Strahlung. Bevorzugte Werte für den maximalen Randstrahlwinkel im zweiten Durchgang nach Reflexion am Spiegel liegen zwischen ca. 10% und ca. 30% der bildseitigen numerischen Apertur. Dadurch wird einerseits erreicht, daß der Lichteinfall im zweiten Durchgang so schräg ist, daß der Strahlteilerwürfel einen Beitrag zur chromatischen Korrektur leisten kann. Andererseits wird eine zu starke Konvergenz vermieden, so daß nach Austritt aus dem Strahlteilerwürfel im Bereich des zweiten Objektivteils 9 noch ausreichend Bauraum für gegebenenfalls erforderliche Korrekturmittel bleibt. Im Beispiel liegt der Betrag des maximalen paraxialen Randstrahlwinkels im ersten Durchgang zwischen erstem Objektivteil und Spiegel bei ca. 35% und im zweiten Durchgang hinter dem Spiegel bei ca. 23% der numerischen Apertur.

Diese günstigen Randstrahlwinkelverhältnisse werden durch eine relativ große Spiegelgruppenbrechkraft ermöglicht, die bei der Ausführungsform ausschließlich durch den Hohlspiegel 8 bereitgestellt wird. Zwischen diesem und dem Strahlteiler befindet sich keine freistehende Linse. Es ist jedoch auch möglich, zwischen Strahlteiler und Hohlspiegel mindestens eine Linse, beispielsweise eine Negativlinse anzuordnen, um eine weitere Korrekturmöglichkeit zu schaffen. Der Konkavspiegel 8 hat einen vergrößernden Abbildungsmaßstab von $\beta=-1{,}534$.

Die Systemblende A liegt bei der gezeigten Ausführungsform im Bereich unmittelbar nach Austritt der Strahlung aus dem Strahlteilerwürfel 5. Dadurch werden auch bei hohen numerischen Aperturen die Strahlhöhen im zweiten Objektivteil 9 relativ gering gehalten, was eine günstige Konstruktion des zweiten Objektivteils insbesondere im Hinblick auf Materialaufwand ermöglicht.

Der zweite Objektivteil 9 ist günstigerweise so konstruiert, daß die Strahlung zur Bilderzeugung ohne Randstrahlaufweitung zur Bildebene 3 gesammelt wird. Dabei sind zwei in Summe brechkraftschwache Linsen 26, 27 vor einem durch die nachfolgenden Linsen 28-32 gebildeten Objektivabschnitt positiver Brechkraft angeordnet.

Für die Erhöhung der numerischen Apertur auf die vorliegenden sehr hohen Werte ist es vorteilhaft, wenn die Systemblende hinter dem Strahlteiler liegt. Hier liegen folgende Überlegungen zugrunde: eine große numerische Apertur bedingt einen großen Spiegeldurchmesser und damit einen großen Abstand zwischen Konkavspiegel und Bildebene bzw. Wafer. Durch die Lagrangesche Invariante, angewandt auf die Pupillenabbildung, ist der Hauptstrahlwinkel an den Durchmesser der Blende gekoppelt in dem Sinne, daß ein kleiner Blendendurchmesser einen großen Hauptstrahlwinkel bedingt und umgekehrt. Wäre die Systemblende am Ort des Hauptspiegels, so wäre bei dem vorliegenden großen Lichtleitwert bei kleinem Blendendurchmesser der Hauptstrahlwinkel am Spiegel so groß bzw. bei großem Blendendurchmesser der Strahlteilerblock so lang, daß die Hauptstrahlhöhe am Austritt des Strahlteilerblockes bereits sehr groß wäre, eventuell größer als die Bildhöhe. In diesem Fall kann für die Linsen des zweiten Objektivteils 9 keine günstige Brechkraftverteilung gefunden werden, welche einerseits einen bildseitig telezentrischen Hauptstrahl und andererseits eine extrem hohe (Randstrahl-)Apertur bei ausreichendem Arbeitsabstand (zum Wafer) erlaubt.

Durch Verlagerung der Systemblende hinter den Strahlteiler kann der Hauptstrahl dagegen rechtzeitig mit Erreichen der richtigen Bildhöhe durch positive Brechkraft kollimiert werden. Um gleichzeitig einen ausreichenden Arbeitsabstand zu gewährleisten wird die positive Brechkraft des zweiten Objektivteils 9 erst nach einer sich im Blendenraum befindlichen brechkraftschwachen Linsengruppe angeordnet.

Da eine mit einem divergierenden Strahlbündel verbundene Randstrahlaufweitung nicht erforderlich ist, kann die axiale Baulänge des zweiten Objektivteils gering gehalten werden. Dies trägt zu einer kompakten Bauweise des gesamten Objektivs 1 bei.

Die "ungezwungene" Strahlführung innerhalb des Objektivs bewirkt als eine vorteilhafte Folge, daß die an den brechenden oder reflektierenden Flächen maximal auftretenden Strahlwinkel gering bleiben, so daß günstige Voraussetzungen für eine wirkungsvolle Transmissionserhöhung durch Beschichtung der Flächen geschaffen sind. Bei der ersten Ausführungsform betragen die maximalen Randstrahlwinkel, mit Ausnahme der drei wafernächsten Flächen, überwiegend weniger als 70% oder 80% der bildseitigen numerischen Apertur.

Weitere Details zu dem dargestellten Design sind aus Tabelle 3 ersichtlich. In Tabelle 3 gibt der Parameter TT (Total Tracklength) die gesamte Baulänge des Objektivs in gestrecktem Aufbau (in mm) wieder. Der Parameter $f_M$ gibt die Brennweite des Konkavspiegel an. Dann ist $|f_M/TT|$ die auf die Baulänge bezogene Brennweite. Die "Brechkraft" des Spiegels ist durch $\phi_M=1/f_M$ gegeben. $\beta_M$ gibt den Abbildungsmaßstab des Hohlspiegels wieder. Die Parameter $u_1$ und $u_2$ bezeichnen die paraxialen Randstrahlwinkel vor bzw. hinter dem Spiegel. Angegeben ist deren Größe in Prozent der bildseitigen numerischen Apertur NA. Das Verhältnis $u_1$ und $u_2$ entspricht dem Abbildungsmaßstab des Spiegels. Weiterhin ist die Arbeitswellenlänge $\lambda$ der Ausführungsformen angegeben.

Das in Fig. 1 gezeigte Design kann ohne wesentliche Änderung von Linsenart und Linsenanordnung auch für andere Arbeitswellenlängen, beispielsweise für eine Arbeitswellenlänge von ca. 193 nm unter Beibehaltung der wesentlichen Merkmale und Vorteile verwendet werden. Ein entsprechendes Design einer zweiten Ausführungsform der Erfindung ist in Tabelle 4 und Tabelle 5 (Asphärendaten) unter Nutzung der obigen Notation dargestellt. Im Unterschied zur ersten Ausführungsform gem. Fig. 1 in Tabelle 1 wird hier synthetisches Quarzglas als Linsenmaterial verwendet. Nur für die letzten beiden, wafernahen Linsen 31 und 32 wurde als Material Flußspat ($CaF_2$) verwendet. Dies dient in diesem Fall nicht der Korrektur chromatischer Farbfehler, sondern der Verminderung von Compaction-Effekten, d.h. von Änderungen von Materialeigenschaften durch hohe Strahlungsbelastung; hier reagiert bekanntlich Calciumfluorid wesentlich unempfindlicher als Siliciumdioxid. Im übrigen unterscheiden sich die Designs von Tabelle 1 und Tabelle 4 nur so geringfügig hinsichtlich der Krümmungsradien der brechenden Flächen ud deren Position, daß eine bildliche Darstellung des 193 nm-Designs sowohl hinsichtlich der optischen Elemente, als auch hinsichtlich der Strahlführung im wesentlichen der Darstellung in Fig. 1 entspricht. Auf eine gesonderte bildliche Darstellung für das auf 193 nm optimierte zweite Ausführungsbeispiel wird daher verzichtet. Das Design erreicht ebenfalls eine numerische Apertur NA=0,85 bei vollständiger chromatischer Korrektur. Weitere Details sind aus Tabelle 3 ersichtlich.

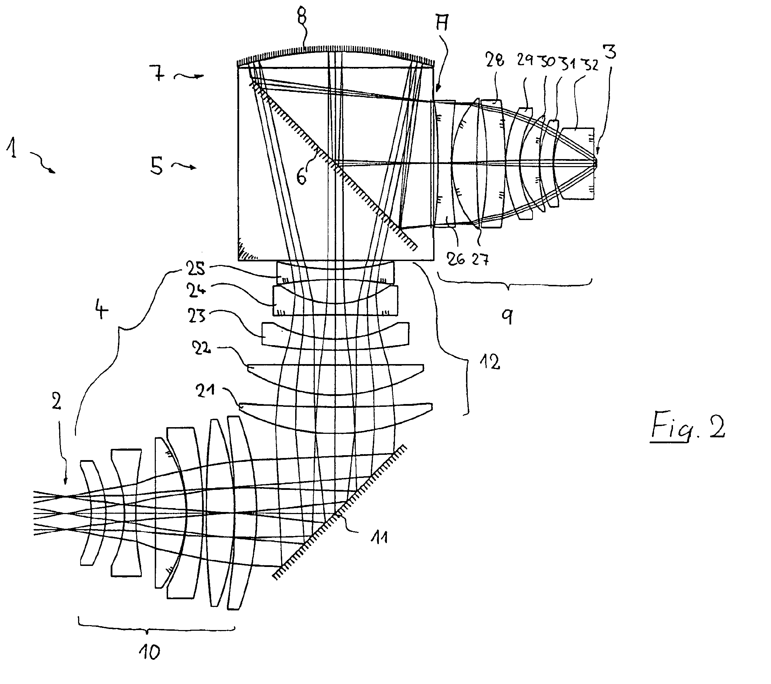

In Fig. 2 ist der Linsenschnitt einer dritten Ausführungsform gezeigt, deren Spezifikation im Detail aus Tabelle 6 und Tabelle 7 (Asphärendaten) sowie Tabelle 3 entnehmbar ist. Das für eine Arbeitswellenlänge von ca. 157 nm ausgelegte Reduktionsobjektiv 1 ist im Grundaufbau der Ausführungsform gem. Fig. 1 ähnlich und stellt wie diese eine numerische Apertur NA von 0,85 bei vollständiger chromatischer Korrektur bereit. Für entsprechende Linsen sind die gleichen Bezugzeichen wie in Fig. 1 verwendet. Auffällige Unterschiede zum Design gem. Fig. 1 bestehen vor allem im Aufbau der dem Umlenkspiegel 11 nachgeschalteten zweiten Linsengruppe 12 des ersten Objektivteils 4. Anstelle der dortigen gegenläufig gekrümmten Menisken 21, 22 sind bei dieser Ausführungsform zur Bündelung des vom Spiegel 11 reflektierten Strahles zwei nahezu plankonvexe Positivlinsen 21, 22 vorgesehen, deren konvexe Eintrittsseiten objektwärts gerichtet sind. Diesen Linsen folgt in vergleichsweise geringem Abstand eine Negativlinse 23 gefolgt von zwei weiteren Negativlinsen 24, 25, so daß im Unterschied zur Ausführungsform gem. Fig. 1 die Erzeugung der Taille im Strahlengang durch drei Negativlinsen erfolgt. Da diese über einen größeren axialen Abschnitt verteilt sind, erfolgt die Taillierung sanfter, so daß insgesamt weniger stark belastete brechende Flächen erforderlich sind.

In dem dem Strahlteiler 5 folgenden zweiten Objektivteil 9 folgen auf die an der Austrittsfläche des Strahlteilers angebrachte Systemblende A eine bikonkave Negativlinse 26 und eine Meniskuslinse 27 positiver Brechkraft. Im Vergleich zur Ausführungsform gem. Fig. 1 ist die im Bereich vor den nachfolgenden Positivlinsen 28-32 versammelte negative Brechkraft größer als bei der obigen Ausführungsform, wodurch die Retrofokuswirkung verstärkt wird und ein größerer Arbeitsabstand erzielbar ist. Diese Ausführungsform vermeidet auch stark gekrümmte Linsenflächen, wie sie bei der Ausführungsform gem. Fig. 1 bei der Meniskuslinse 28 auftreten.

Eine der Ausführungsform gem. Fig. 2 sehr ähnliche vierte Ausführungsform mit geringfügig anderen Linsenradien- und positionen ist aufgrund der Ähnlichkeit zum Aufbau gem. Fig. 2 nicht bildlich dargestellt sondern nur in Tabelle 8 und Tabelle 9 sowie in Tabelle 3 angegeben.

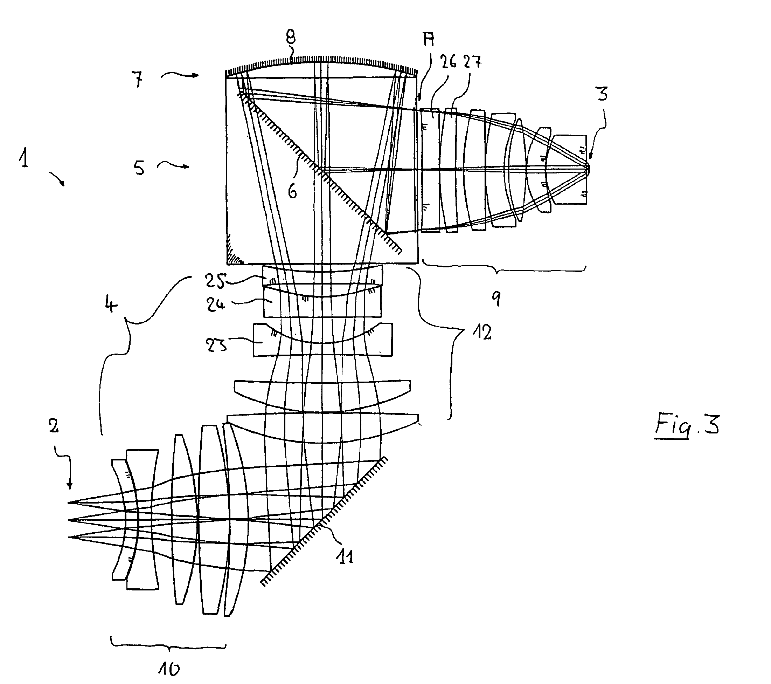

In Fig. 3 ist eine für eine Arbeitslänge von 157 nm ausgelegte fünfte Ausführungsform gezeigt, die bei einer numerischen Apertur NA=0,80 eine vollständige chromatische Korrektur ermöglicht. Details zur Anordnung und Ausbildung der hierbei verwendeten optischen Elemente sind in Tabelle 10 und Tabelle 11 (Asphärendaten) sowie in Tabelle 3 angegeben. Ein Vergleich mit dem Aufbau in Fig. 2 zeigt hinsichtlich des Aufbaus des ersten Objektivteils 4 nur geringfügige Unterschiede. Als signifikanter Unterschied zum dortigen Designs ist erkennbar, daß im zweiten Objektivteil 9 die Strahlaufweitung im Bereich der dem Strahlteiler 5 unmittelbar nachgeschalteten Linsen 26, 27 schwächer ausfällt als in den oben dargestellten Ausführungsformen, so daß nur eine schwache Wirkung der Retrofokusanordnung eintritt. Aufgrund der niedrigen numerischen Apertur ist dennoch ein ausreichender Arbeitsabstand gewährleistet. Als ein Vorteil dieser Ausführungsform ist erkennbar, daß die der Doppellinsenanordnung 26, 27 nachfolgenden Linsen 28-32 mit insgesamt positiver Brechkraft günstiger als bei den obigen Ausführungsformen gestaltet sein können. Hier treten auch geringere Inzidenzwinkel der Randstrahlen auf, was die Beschichtung dieser Linsen erleichtert. Zudem sind anstatt acht nur sieben asphärische Flächen vorgesehen.

In Fig. 4 ist eine für 157 nm ausgelegte sechste Ausführungsform mit bildseitiger numerischer Apertur NA=0,85 und vollständiger chromatischer Korrektur gezeigt. Konstruktive Details zu diesem Design sind Tabelle 12 und Tabelle 13 (Asphärendaten) sowie Tabelle 3 entnehmbar. Der Aufbau des ersten Objektivteils 4 und des zweiten Objektivteils 9 unterscheidet sich nur wenig von den in Fig. 2 gezeigten Aufbau der dritten Ausführungsform. Ein wesentlicher Unterschied zu den obigen Designs besteht darin, daß bei der sechsten Ausführungsform der Strahlteiler 5 eine von der Würfelform abweichende Form, nämlich die eines Strahlteilerquaders mit ungleichen Kantenlängen aufweist. Die Strahlteilerform dieses besonders materialsparenden Designs ergibt sich aus der Überlegung, daß bei herkömmlichen Strahlteilerwürfeln häufig größere Volumenabschnitte nicht zur optischen Wirkung beitragen und daher weggelassen werden können. Dementsprechend ist der Strahlteiler 5 im Hinblick auf das für die optische Abbildung notwendige Materialvolumen minimiert oder dieser Minimalform zumindest angenähert. In dem gezeigten Beispiel ist dies dadurch erreicht, daß im Vergleich zur Ausführungsform gem. Fig. 2 die ebene Eintrittsfläche F24 und die ebene Austrittsfläche F29 des Strahlteilerblockes unter Parallelverschiebung näher zur Strahlteilerfläche 6 gerückt sind. Die durch diese Maßnahme im Vergleich zum Strahlteilerwürfel eingesparten Überschußvolumina sind durch die gestrichelten Linien 33, 34 angedeutet. Die Lageänderungen der Eintritts- bzw. Austrittsfläche und die damit verbundene Erzeugung eines geometrisch minimierten Strahlteilerquaders bedingt gegebenenfalls geringe Modifikationen des Gesamtdesigns im Vergleich zum Ausgangswürfel. Es wäre auch möglich, auf der dem zweiten Objektivteil 9 gegenüberliegenden Seite des Strahlteilers 5 durch einen gegebenenfalls schrägen Schnitt beispielsweise entlang Linie 35 Material zu sparen, indem für die Abbildung nicht erforderliches, weil nicht durchstrahltes Materialvolumen vom Block 5 abgetrennt wird. Daher können gegebenenfalls auch irreguläre Formen eines Strahlteilerblockes im Hinblick auf Materialeinsparung günstig sein. Durch eine Anpassung der Außenkontur des Strahlteilerblockes an die Form des maximal durchstrahlten Bereiches sind also erhebliche Materialeinsparungen möglich. Vorzugsweise beträgt das maximal durchstrahlte Materialvolumen mehr als ca. 70%, insbesondere mehr als 80% des Außenvolumens des Strahlteilerblockes, so daß nur wenig ungenutztes Materialvolumen verbleibt.

Diese beispielhaft beschriebenen Maßnahmen zur Minimierung des Materialvolumens eines Strahlteilerblok-

kes können nicht nur bei den Designs der Erfindung vorteilhaft sein, sondern auch bei nicht erfindungsgemäßen Strahlteilern in anderen katadioptrischen Projektionsobjektiven und/oder anderen optischen Einrichtungen.

Allen Ausführungsformen ist gemeinsam, daß ein materialsparender Aufbau des Designs realisiert ist. Die Maßnahmen zur Materialeinsparung im Bereich des Strahlteilerblocks 5 wurden anhand der Ausführungsform gemäß Fig. 4 erläutert. Um eine gute, monochromatische Korrektur (hohe Abbildungsleistung, niedrige Aberrationen) bei den erreichten sehr großen numerischen Aperturen bei geringem Materialeinsatz zu erreichen, sind bei allen Ausführungsformen mehrere asphärische Flächen vorgesehen, i.d.R. nicht mehr als acht, bei niedrigerer Apertur (Ausführungsform gem. Fig. 3) auch nur sieben. Durch Einsatz von Asphären kann ein verringerter Materialeinsatz sowohl hinsichtlich Linsenmasse, als auch Anzahl der Linsen erreicht werden. Eine möglichst geringe Anzahl optischer Flächen ist besonders bei Ausführungsform für kurze Wellenlängen, beispielsweise 157 nm oder weniger, vorteilhaft, weil für diese kurzen Wellenlängen eine ausreichende Entspiegelung von Flächen durch Beschichtung häufig nur mit Schwierigkeiten möglich ist. Eine Verringerung der Flächenzahl ist daher zur Erreichung einer ausreichenden Gesamttransmission des Objektives vorteilhaft.

Bei jedem der gezeigten Ausführungsbeispiele ist mindestens eine asphärische Fläche im Bereich der Systemblende A vorgesehen. Asphärische Flächen nahe der Blende sind besonders wirksam für die Korrektur des sphärischen Aberration und von Koma. Entsprechend ist bei allen Ausführungsformen die dem Strahlteiler zugewandte, bildseitige Fläche der ersten Linse des zweiten Objektivteils 9 asphärisch, bei der Ausführungsform gem. Fig. 2 auch die bildseitige Eintrittsfläche der folgenden Linse. Günstig werden diese Asphären im Bereich großer Randstrahlhöhen eingesetzt, beispielsweise dort, wo das Verhältnis zwischen Randstrahlhöhe h und dem Radius $\phi$ der Öffnung der Systemblende zwischen ca. 0,8 und ca. 1,2 liegt.

Desweiteren sind bei allen Ausführungsformen asphärische Flächen zur Korrektur der Verzeichnung und/oder anderer Feldaberrationen eingesetzt. Die Asphären sind so angeordnet, daß bei ihnen das Verhältnis $h/\phi$ zwischen Randstrahlhöhe h und dem Radius $\phi$ der Systemblende kleiner als ca. 0,8 ist.

## Patentansprüche

1. Katadioptrisches Projektionsobjektiv zur Abbildung eines in einer Objektebene (2) angeordneten Musters in eine Bildebene (3), wobei zwischen der Objektebene und der Bildebene in dieser Reihenfolge ein erster Objektivteil (4) zur Erzeugung eines auf einen physikalischen Strahlteiler (5) gerichteten Strahls, ein physikalischer Strahlteiler mit einer Strahlteilerfläche (6), eine Spiegelgruppe (7) mit einer Spiegelgruppenbrechkraft und einem Konkavspiegel (8), und ein zweiter Objektivteil (9) mit positiver Brechkraft zur Erzeugung eines Bildes des Musters in der Bildebene angeordnet sind, wobei die Spiegelgruppenbrechkraft groß ist und die Systemblende (A) bildseitig hinter dem Konkavspiegel (8) liegt.

2. Projektionsobjektiv nach Anspruch 1, **dadurch gekennzeichnet, daß** die Systemblende (A) zwischen der Strahlteilerfläche (6) und der Bildebene (2) liegt, insbesondere nahe bei oder an einer bildseitigen Austrittsfläche des Strahlteilers (5).

3. Projektionsobjektiv nach Anspruch 1 oder 2, **dadurch gekennzeichnet, daß** die Spiegelgruppenbrechkraft so bemessen ist, daß eine auf die Spiegelgruppe (7) treffende divergente Strahlung in eine konvergente Strahlung umwandelbar ist, wobei die Spiegelgruppenbrechkraft so bemessen ist, daß die Summe der Beträge der Randstrahlwinkel der auf die Spiegelgruppe (7) treffenden Strahlung und der von der Spiegelgruppe austretenden Strahlung groß gegen Null ist, wobei diese Betragssumme der paraxialen Randstrahlwinkel vorzugsweise mehr als 30% der numerischen Apertur beträgt und insbesondere bei ca. 60% der numerischen Apertur liegt.

4. Projektionsobjektiv nach einem der vorhergehenden Ansprüche, **dadurch gekennzeichnet, daß** der erste Objektivteil (4) zur Erzeugung eines auf den Strahlteiler gerichteten divergenten Strahls ausgebildet ist, wobei vorzugsweise der erste Objektivteil (4) so ausgelegt ist, daß der austretende divergente Strahl einen minimalen Randtrahlwinkel von mehr als 20% der bildseitigen numerischen Apertur des Projektionsobjektives hat, wobei dieser Randstrahlwinkel vorzugsweise im Bereich zwischen 30% und ca. 40% der bildseitigen numerischen Apertur liegt.

5. Projektionsobjektiv nach einem der vorhergehenden Ansprüche, **dadurch gekennzeichnet, daß** der erste Objektivteil vor dem Strahlteiler (5) negative Brechkraft, vorzugsweise mindestens zwei Negativlinsen (23, 24, 25), zur Erzeugung einer Taille im Strahlengang aufweist.

6. Projektionsobjektiv nach einem der vorhergehenden Ansprüche, **dadurch gekennzeichnet, daß** die Spiegelgruppenbrechkraft so bemessen ist, daß der Strahl bildseitig hinter der Spiegelgruppe (7) konvergent ist, und/oder daß der aus der Spiegelgruppe bildseitig austretende Strahl einen Randstrahlwinkel hat, der größer als ca. 10% der bildseitigen numerischen Apertur ist, wobei der Randstrahlwinkel vorzugsweise maximal ca. 30% der bildseitigen numerischen Apertur beträgt, und/oder daß der Betrag des Randstrahlwinkels der auf die Spiegelgruppe (7) treffenden Strahlung größer ist als der Betrag des Randstrahlwinkels der von der Spiegelgruppe (7) ausgehenden Strahlung.

**7.** Projektionsobjektiv nach einem der vorhergehenden Ansprüche, **dadurch gekennzeichnet, daß** zwischen der Strahlteilerfläche (6) und dem Konkavspiegel (8) keine freistehende Linse angeordnet ist.

**8.** Projektionsobjektiv nach einem der vorhergehenden Ansprüche, **dadurch gekennzeichnet, daß** der Konkavspiegel (8) einen vergrößernden Abbildungsmaßstab hat.

**9.** Projektionsobjektiv nach einem der vorhergehenden Ansprüche, **dadurch gekennzeichnet, daß** der erste Objektivteil (4) einen Umlenkspiegel (11), eine erste Linsengruppe (10) zwischen Objektebene (2) und Umlenkspiegel (11) und eine zweite Linsengruppe (12) zwischen Umlenkspiegel (11) und Strahlteiler (5) aufweist.

**10.** Projektionsobjektiv nach einem der vorhergehenden Ansprüche, **dadurch gekennzeichnet, daß** der zweite Objektivteil (9) nach Art eines Retrofokusobjektivs aufgebaut ist, wobei vorzugsweise zwischem dem Strahlteiler (5) und bildseitigen Linsen (28 bis 32) mit insgesamt positiver Brechkraft mindestens eine Linse (27) mit negativer Brechkraft angeordnet ist.

**11.** Projektionsobjektiv nach einem der vorhergehenden Ansprüche, **dadurch gekennzeichnet, daß** die Strahlteilerfläche (6) an einem Strahlteiler (5) als Tragkörper angeordnet ist und daß die Systemblende (A) außerhalb des Strahlteilers angeordnet ist, und/oder daß die Strahlteilerfläche (6) im wesentlichen diagonal in einem Strahlteilerblock angeordnet ist.

**12.** Projektionsobjektiv nach einem der vorhergehenden Ansprüche, **dadurch gekennzeichnet, daß** die Strahlteilerfläche (6) in einem Strahlteilerblock angeordnet ist, der vorzugsweise eine von der Würfelform abweichende, insbesondere quaderförmige optische Minimalform hat, wobei vorzugsweise das maximal durchstrahlte Materialvolumen mehr als 70%, insbesondere mehr als 80% des Außenvolumens des Strahlteilerblocks beträgt, und/oder daß die Strahlteilerfläche (6) im Lichtweg von der Objektebene zum Konkavspiegel (8) in Transmission genutzt wird.

**13.** Projektionsobjektiv nach einem der vorhergehenden Ansprüche, **dadurch gekennzeichnet, daß** die Strahlteilerfläche (6) eine Polarisationsstrahlteilerfläche ist und daß zwischen der Strahlteilerfläche (6) und dem Konkavspiegel (8) eine Viertelwellenplatte angeordnet ist.

**14.** Projektionsobjektiv nach einem der vorhergehenden Ansprüche, **dadurch gekennzeichnet, daß** alle transparenten optischen Komponenten, insbesondere alle Linsen und der Strahlteiler, aus dem gleichen Material bestehen, insbesondere aus kristallinem Fluorid, vorzugsweise Calciumfluorid, oder aus synthetischem Quarzglas.

**15.** Projektionsobjektiv nach einem der vorhergehenden Ansprüche, **dadurch gekennzeichnet, daß** der zweite Objektivteil (9) keine zur chromatischen Korrektur vorgesehenen Korrekturmittel aufweist, die ein erstes Linsenmaterial und ein zweites Linsenmaterial abweichender Dispersion umfassen.

**16.** Projektionsobjektiv nach einem der vorhergehenden Ansprüche, **dadurch gekennzeichnet, daß** seine bildseitige numerische Apertur mehr als ca. 0,7 beträgt, wobei die bildseitige numerische Apertur vorzugsweise mindestens ca. 0,8 beträgt, insbesondere ca. 0,85.

**17.** Projektionsobjektiv nach einem der vorhergehenden Ansprüche, **dadurch gekennzeichnet, daß** es so konstruiert ist, daß das Muster ohne Erzeugung eines Zwischenbildes in die Bildebene abgebildet wird.

**18.** Projektionsobjektiv nach einem der vorhergehenden Ansprüche, **dadurch gekennzeichnet, daß** es bildseitig und vorzugsweise auch objektseitig telezentrisch ausgebildet ist.

**19.** Projektionsobjektiv nach einem der vorhergehenden Ansprüche, **dadurch gekennzeichnet, daß** es mindestens eine optische Komponente, insbesondere mindestens eine Linse, mit mindestens einer asphärischen Fläche aufweist.

**20.** Projektionsobjektiv nach einem der vorhergehenden Ansprüche, **dadurch gekennzeichnet, daß** mindestens eine asphärische Fläche im Bereich der Systemblende (A) und mindestens eine asphärische Fläche im Bereich der Objektebene (2) und/oder der Bildebene (3) angeordnet ist.

**21.** Projektionsbelichtungsanlage für die Mikrolithographie, **dadurch gekennzeichnet, daß** sie ein katadioptrisches Projektionsobjektiv gemäß einem der vorhergehenden Ansprüche umfaßt.

**22.** Verfahren zur Herstellung von Halbleiterbauelementen und anderen feinstrukturierten Bauteilen mit folgenden Schritten:

Bereitstellung einer Maske mit einem vorgegebenen Muster;
Beleuchtung der Maske mit Ultraviolettlicht einer vorgegebenen Wellenlänge; und
Projektion eines Bildes des Musters auf ein im Bereich der Bildebene eines Projektionsobjektivs angeordnetes, lichtempfindliches Substrat mit Hilfe eines katadioptrischen Projektionsobjektivs gemäß einem der vorhergehenden Ansprüche 1-20.

Fig. 1

Fig. 2

Fig. 3

EP 1 227 354 A2

Fig. 4